# EUROPÄISCHE PATENTSCHRIFT

(11) **EP 2 158 625 B1**
(45) Veröffentlichungstag und Bekanntmachung des Hinweises auf die Patenterteilung: **15.02.2017**
(21) Anmeldenummer: 08773272.3
(22) Anmeldetag: 18.06.2008
(51) Int. Cl.: H01L 51/54, C07F 15/00

(54) **VERWENDUNG EINES METALLKOMPLEXES ALS P-DOTAND FÜR EIN ORGANISCHES HALBLEITENDES MATRIXMATERIAL, ORGANISCHES HALBLEITERMATERIAL UND ORGANISCHE LEUCHTDIODEN**
USE OF A METAL COMPLEX AS A P-DOPANT FOR AN ORGANIC SEMICONDUCTIVE MATRIX MATERIAL, ORGANIC SEMICONDUCTOR MATERIAL, AND ORGANIC LIGHT-EMITTING DIODES
UTILISATION D'UN COMPLEXE MÉTALLIQUE COMME DOPANT P POUR UN MATÉRIAU DE MATRICE SEMICONDUCTEUR ORGANIQUE, MATÉRIAU DE MATRICE SEMICONDUCTEUR ORGANIQUE ET DIODES ÉLECTROLUMINESCENTES ORGANIQUES

(30) Priorität: 20.06.2007 DE 102007028238
(43) Veröffentlichungstag der Anmeldung: 03.03.2010
(60) Teilanmeldung: 16203223.9
(73) Patentinhaber: OSRAM OLED GmbH, 93049 Regensburg (DE)
(72) Erfinder: SCHMID, Günter, 91334 Hemhofen (DE); KRAUSE, Ralf, 91058 Erlangen (DE)
(74) Vertreter: Epping - Hermann - Fischer
(86) Internationale Anmeldenummer: PCT/DE2008/001033
(87) Internationale Veröffentlichungsnummer: WO 2008/154914

(56) Entgegenhaltungen:
- EP-A- 1 289 030
- EP-A- 1 860 709
- WO-A-2005/036667
- WO-A-2005/086251
- JP-A- 3 208 689
- US-A1- 2004 241 492
- YAMASHITA K ET AL: "FABRICATION OF AN ORGANIC P-N HOMOJUNCTION DIODE USING ELECTROCHEMICALLY CATION- AND PHOTOCHEMICALLY ANION-DOPED POLYMER" JAPANESE JOURNAL OF APPLIED PHYSICS, JAPAN SOCIETY OF APPLIED PHYSICS, TOKYO, JP, Bd. 34, Nr. 7B, 1. Juli 1995 (1995-07-01), Seiten 3794-3797, XP000703013 ISSN: 0021-4922
- F.A. COTTON, E.V. CIKAREV, M.A. PETRUKHINA, S.-E. STIRIBA: POLYHEDRON, Bd. 19, 2000, Seiten 1829-1835, XP002494592

## Beschreibung

Die Erfindung betrifft die Verwendung eines Metallkomplexes als p-Dotand für ein organisches halbleitendes Matrixmaterial, ein organisches Halbleitermaterial und organische Leuchtdiode.

Die Dotierung organischer halbleitender Materialien mit Elektronenakzeptoren zur Erhöhung der Leitfähigkeit in organischen Matrixmaterialien ist beispielsweise aus der WO 2005/086251 bekannt. Dort werden Metallkomplexe, insbesondere mehrkernige Metallkomplexe wie die so genannten Schaufelradkomplexe (paddle-wheel) wegen ihrer starken Donoreigenschaften als n-Dotanden für die Elektroneninjektion beschrieben.

Die US 2004/0241492 A1 beschreibt die Verwendung von Nickelkomplexen als Dotierstoffe für Polymere in einer Lochinjektionsschicht.

In Yamashita et al., Jpn. J. Appl. Phys. Vol. 34 (1995) pp.3794-3797 wird der Komplex [Ru(bpy)₃]²⁺ als p-dotierendes Material beschrieben.

Die JP 03-208689 beschreibt Bis-Dithiolato-Nickel-Komplexe als Dotierstoffe.

Es besteht jedoch ein Bedarf, p-Dotanden zur Dotierung der Lochinjektionsschicht zur Verfügung zu stellen.

Aufgabe der vorliegenden Erfindung ist es daher, p-Dotanden für eine lochleitende Matrix anzugeben und die Verwendungen derart dotierter lochleitender Matrixmaterialien in einer strahlungsemittierenden Vorrichtung, insbesondere einer organischen Leuchtdiode (OLED), zu offenbaren.

Diese Aufgabe wird durch die Merkmale der unabhängigen Ansprüche, insbesondere durch die Verwendung von neutralen Metallkomplexen mit Lewis-Säure Charakter als p-Dotanden in lochleitenden organischen Matrixmaterialien gelöst. Ferner wird die Aufgabe durch die Bereitstellung eines organischen halbleitenden Materials mit einer Verbindung eines solchen Metallkomplexes mit Lewis-Säure Charakter als p-Dotand gelöst. Schließlich wird die Aufgabe noch durch die Angabe von OLEDs mit zumindest einer Schicht eines erfindungsgemäßen organischen Matrixmaterials gelöst.

Gegenstand der Erfindung ist die Verwendung eines neutralen Metallkomplexes mit Lewis-Säure Eigenschaften als p-Dotand eines organischen halbleitenden Matrixmaterials. Weiterhin ist Gegenstand der Erfindung eine Lochleiterschicht, bestehend aus einem lochleitenden organischen Matrixmaterial mit einem Anteil von 0,1 bis 50 (Schichtdicken%) an Metallkomplex als p-Dotanden. Schließlich ist Gegenstand der Erfindung eine OLED, zumindest eine Schicht eines dotierten Lochleitermaterials umfassend, das einen Metallkomplex als p-Dotanden enthält.

Erfindungsgemäß wird die Verwendung eines mehrkernigen Metallkomplexes als p-Dotand zur Dotierung eines lochleitenden organischen Matrixmaterials angegeben. Der mehrkernige Metallkomplex ist ein Metallkomplex mit Lewissäureeigenschaft und wirkt als Elektronenpaarakzeptor.

Lewis-Säuren sind Verbindungen, die als Elektronenpaarakzeptoren wirken. Eine Lewis-Base ist dementsprechend ein Elektronenpaardonator, der Elektronenpaare abgeben kann. Insbesondere ist die Lewis-Säure-Eigenschaft der Metallkomplexe in Bezug auf das lochleitende organische Matrixmaterial zu setzen, das dann die korrespondierende Lewis-Base darstellt (bzw. enthält).

Ein Metallkompex ist eine Verbindung, in der ein Metallatom bzw. Metallion von einem oder mehreren Liganden koordiniert ist. Im Regelfall ist der Metallkomplex eine metallorganische Verbindung, d.h. ein Komplex, bei dem zumindest ein Teil der Liganden Kohlenstoff-haltig und häufig auch Kohlenwasserstoff-haltig ist.

Erfingdungsgemäß handelt es sich bei dem Metallkomplex um einen mehrkernigen Komplex, insbesondere um einen Komplex mit zumindest einer Metall-Metallbindung.

Nach einer vorteilhaften Ausführungsform ist zumindest ein Zentralatom des Metallkomplexes ausgewählt aus der Gruppe der Platinmetalle, folgende Elemente umfassend: Ruthenium, Rhodium, Palladium, Osmium, Iridium und Platin. Insbesondere sind Rhodiumkomplexe bevorzugt.

Nach einer vorteilhaften Ausführungsform ist das Zentralatom ein neutrales oder geladenes, insbesondere positiv geladenes, Übergangsmetallatom.

Unter Lochleitern werden die typische Materialien, die in der OLED lochleitend wirken, wie NPB (N,N'-di-1-napthyl-diphenyl-benzidin, HOMO = 5,5 eV; LUMO = 2,4 eV) oder Naphdata (4,4',4'-Tris(N-(1-naphthyl)-N-phenyl -amino)-triphenylamin; HOMO = 5,1 eV; LUMO = 2,3 eV) verstanden.
Die Dotierung wird im Folgenden in relativen Schichtdicken angeben d.h. x % bedeutet, dass die Depositionsrate des Dotanden x % im Bezug auf die Depositionsrate der Matrix beträgt.

Vorteilhafterweise wird als neutraler Metallkomplex ein Komplex mit einer so genannten "paddle-wheel / Schaufelrad" Struktur eingesetzt, wobei besonders bevorzugt zwei- und mehrkernige Metallkomplexe mit zumindest einer Metall-MetallBindung verwendet werden, wie sie beispielsweise aus "Cotton FA, Gruhn NE, Gu J, Huang P, Lichtenberger DL, Murillo Ca, Van Dorn LO und Wilkinson CC: "Closed Shell Molecules That Ionize More Readily Than Cesium" in Science, 2002, 298; 1971-1974 bekannt sind. Ebenfalls beschrieben werden diese Strukturen in der WO 2005/086251. Dort wird jedoch davon ausgegangen, dass mehrkernige Metallkomplexe mit Schaufelradstruktur "paddle-wheel" als n-Dotanden wirken. Dies trifft aber nicht auf alle Paddle-Wheel-Komplexe bzw. die dort genannten Strukturen zu, wie vorliegend gezeigt werden konnte.

In der WO 2005/086251 A2 werden Komplexe mit Schaufelradstruktur als typische n-Dotanden vorgestellt. Um die Verwendbarkeit von Dirhodium-tetra-trifluoroacetat (PDW-2), einem typischen Vertreter der Metallkomplexe mit starkem Lewis-Säure Charakter, wie sie vorliegend als p-Dotanden unter Schutz gestellt werden sollen, als n-Dotand zu überprüfen, wurde folgendes Experiment durchgeführt:

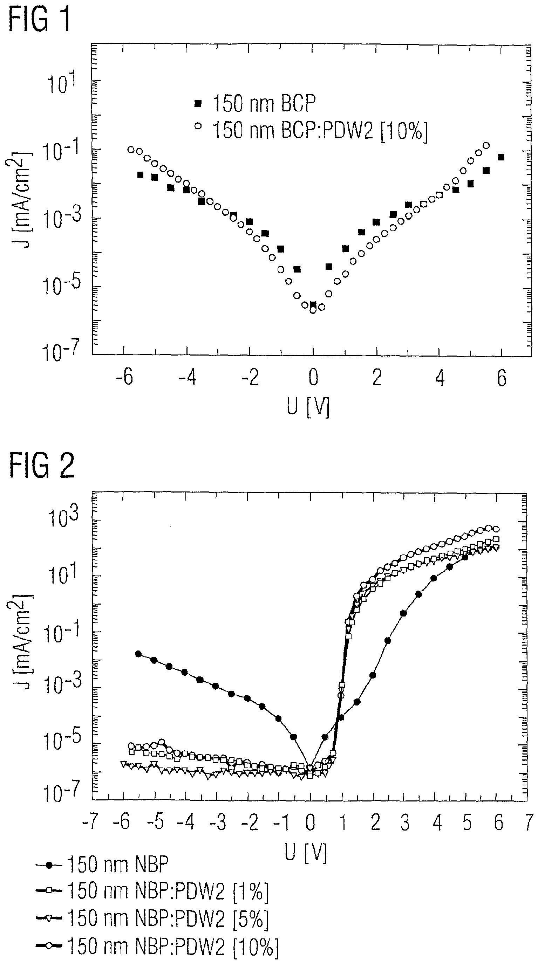

Auf einer ITO (Indium-tin-oxide = indiumdotiertes Zinnoxid) Elektrode wurde durch thermisches Verdampfen eine 150 nm dicke Schicht des Elektronenleiters BCP (= 2,9-Dimethyl-4,7-diphenyl-1,10-phenantholin) abgeschieden. Als Gelegenelektrode diente eine 150 nm dicke Aluminiumschicht. Figur 1 zeigt das Ergebnis, wobei ein 4 mm² großes Bauelement gemessen wurden das die durch Quadrate markierte typische Kennlinie ergab (Figur 1 Quadrate).

In einem zweiten Experiment werden in die BCP-Schicht durch Koverdampfung 10% PDW-2 eindotiert. Die durch Kreise in Figur 1 markierte Kennlinie unterscheidet sich nur unwesentlich von der Kennlinie des reinen BCP. Damit ist PDW-2 generell nicht als n-Dotand einsetzbar, insbesondere nicht in einer OLED und den darin verwendeten typischen Elektronenleitern mit einem typischen HOMO im Bereich 5,8 - 6,2 eV bzw. einem typischen LUMO im Bereich von 3,0 - 2,4 eV.

Analog zum oben beschriebenen Experiment wird PDW-2 durch Koverdampfung in den Lochleiter NPB (= Bis-N,N,N',N'-(naphthyl-phenyl)benzidin) eindotiert. Für eine Dotierung von 0% (Kreise voll), 1%( Quadrate), 5%(Dreiecke) und 10% (Kreise leer) ergaben sich die in Figur 2 dargestellten Kennlinien.

Diese demonstrieren eindeutig die Möglichkeit zur p-Dotierung von lochleitenden Matrixmaterialien durch PDW-2. Erstaunlicherweise können aus Aluminium keine Löcher injiziert werden (negativer Ast der x-Achse), wodurch sich ein Gleichrichtungsfaktor von 3·10⁻⁷ ergibt. Für eine effektive Dotierung reichen nur wenige relative Schichtdicken % aus (insbesondere 0 - 50%, besonders bevorzugt 0 - 15 %). Die Kennlinien zwischen 1 - 10% PDW-2 in NPB sind nahezu identisch. Die Kennlinien sind zudem sehr steil. Bei höheren Spannungen sättigt die Kennlinie, wodurch ein strombegrenzendes Verhalten resultiert.

Die Dotierung organischer Matrixmaterialien mit p-Dotanden ist von entscheidender Relevanz für organische Leuchtdioden. Lumineszenz (cd/m²), Effizienz (cd/A) und Lebensdauer (h) organischer Leuchtdioden hängen stark von der Exzitonendichte in der lichtemittierenden Schicht und der Qualität der Ladungsträgerinjektion ab und werden unter anderem auch durch diese limitiert. Dotierte Transportschichten haben den Vorteil, dass an ihnen relativ zum Gesamtaufbau nur ein Bruchteil der zum Betrieb nötigen Spannung abfällt (<< 30%). Besonders bevorzugt ist die abfallende Spannung sogar um eine Zehnerpotenz oder mehr kleiner, so dass an den Transportschichten kein Spannungsabfall beobachtet wird.

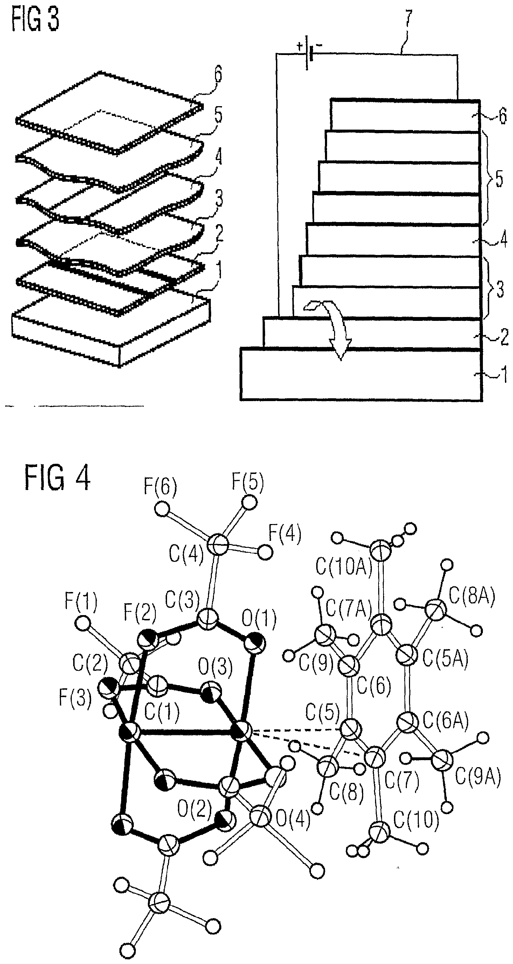

Figur 3 zeigt den Aufbau einer OLED mit einzelnen Funktionsschichten. Zu erkennen ist die unterste und gleichzeitig dickste Schicht 1, die das Substrat, beispielsweise aus Quarz, Glas oder einer Metall- oder Polymerfolie, darstellt. Darauf liegt die transparente Elektrode 2, Z.B. eine Elektrode aus einem transparenten leitenden Oxid. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO3, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Im Fall von Top-emittierenden Dioden kann die Elektrode (2) eine (nicht transparente) Schicht aus Metallen sein. Das Substrat kann dann z.B. eine nicht durchsichtige Metallfolie sein. In Figur 3 ist beispielsweise eine ITO-Anode dargestellt. Auf dieser unteren Elektrode liegt die Lochleiterschicht 3, die gemäß der Erfindung aus einem organischen Matrixmaterial gebildet ist, das mit einem Metallkomplex, der eine Lewissäure darstellt dotiert ist.
Auf der Lochleiterschicht 3 liegt die eigentlich aktive Schicht der OLED, die emittierende Schicht 4. Darauf befindet sich noch die Elektronentransportschicht 5 und die Gegenelektrode 6. Die emittierende Schicht 4 kann z.B. eine organische funktionelle Schicht, z.B. auf der Basis von Polymeren wie Poly(p-phenylen-vinylen) (PPV) oder auf der Basis von so genannten niedermolekularen kleinen Molekülen ("small molecules") wie z.B. Tris(8-hydroxyquinolato)-aluminium (Alq) sein. Weiterhin kann es sich z.B. um phophoreszente Triplettemitter wie Tri(phenylpyridino)Iridium(III), eindotiert in ein Matrixmaterial Bis-N,N'-(carbazoylbiphenyl (CPB), handeln. Die Emitterschicht kann auch aus vielen Einzelemitterschichten bestehen wobei z.B. rotes, grünes oder blaues Licht emittiert wird. Zusätzlich zu den gezeigten Schichten 1 bis 6 ist noch der Schutz der OLED mittels einer Verkapselung zweckmäßig.

Über die elektrische Leitung 7 werden die Elektroden mit der Spannungsquelle verbunden.

Bei großflächigen Leuchtelementen spielt die Homogenität der Ladungsinjektion eine wichtige Rolle. Partikel, Kristallite oder Spitzen verursachen Feldüberhöhungen und damit potentielle Ausgangspunkte für "dark spots" die zum Ausfall des Leuchtelements führen können. Durch eine Lochinjektionsschicht, in die beispielsweise zweikernige Rhodiumacetatbasierte "paddle-wheel"-Komplexe eingebettet sind, kann eine Schicht erzeugt werden, die eine unerwartet hohe Stromtragfähigkeit in Verbindung mit einer inhärenten Strombegrenzung zeigt.

Bevorzugt werden Rhodiumkomplexe eingesetzt, wie Metallkomplex-Verbindungen mit einem Rh₂⁴⁺ Kern und einer Metall-Metallbindung, die aufgrund ihres hohen Lewis-Säure-Charakters als p-Dotand und Elektronenakzeptor wirken.

Besonders bevorzugt ist das Dirhodiumtetratrifluoracetat (Fig. 4), das sich aufgrund seiner günstigen Sublimationseigenschaften sehr gut eignet. In der chemischen Literatur [F. A. Cotton, C. A. Murillo, R. A. Walton "Multiple Bonds between Metal Atoms" 3. Auflage, Springer Science and Business Media, Inc. 2005. 465-611.] konnte unerwarteter Weise auch kristallografisch gezeigt werden, dass sogar unsubstituierte Aromaten als Donor für den Rh₂⁴⁺-Kern in axialer Position dienen können. Experimentell konnte durch die Dotierung von NPB oder Naphdata (Naphdata =4,4',4"-Tris((N-naphthyl)-N-phenyl-amino)-triphenylamin)mit PDW-2 in oben beschriebenen Experimenten gezeigt werden, dass dieser Vorgang eine p-Dotierung bewirkt.

Figur 4 zeigt die Struktur von Rh₂(CF₃COO)₄, an die das aromatische System Hexamethylbenzol koordiniert ist.

Auch die zu Rh₂⁴⁺-Komplexen isoelektronischen Metallkomplexe zu dieser Struktur, insbesondere solche, die noch ähnliche Größen zeigen wie beispielsweise ein Analogon mit Ru₂²⁺-Ionen als Zentralatome sind ebenfalls geeignet als p-Dotanden. Diese bewirken zum einen die Schaufelradstruktur und zum anderen die sehr hohe Lewis-Säure Azidität dieser Komplexe. Insbesondere geeignet sind die als p-Dotanden geeigneten Zentralatome bzw. Metallkomplexe, die direkt an aromatische Systeme, wie z.B. ungeladene aromatische Systeme koordinieren können. Als Zentralatome kommen daher insbesondere die Metalle der 6. bis 9. Nebengruppe in Betracht

Bei einem paddle-wheel-Komplex sind mindestens zwei, zumeist genau zwei Metallzentralatome insbesondere Übergangsmetallatome, durch 1, 2 ,3 ,4 oder mehr mehrzähnige (insbesondere zweizähnige) Liganden, die an die mindestens zwei Metallzentralatome jeweils ein Ligandenatom binden, überbrückt. Die Metallatome sind hierbei, je nach Radius, zumeist 4-fach mit den genannten Liganden koordiniert.
Der Lewissäurecharakter der paddle-wheel-Komplexe ist insbesondere dadurch gegeben, dass zumindest an einem Metallatom eine lockere oder leere Koordinationsstelle vorhanden ist, an der beispielsweise die Anlagerung eines aromatischen Ringes, wie in Figur 4 gezeigt, stattfinden kann. Die Koordinationsumgebung des Metallatoms ist bevorzugt so, dass eine Metall-Metall-Bindung besteht sowie 4 äquatoriale Bindungen zu Liganden. Im Regelfall weist daher die axiale Position die lockere oder leere Koordinationsstelle auf, wodurch der Komplex je nach Ligand und Zentralatom Lewis-azid ist.

Als Liganden eignen sich insbesondere alle zwei -oder mehrzähnigen Liganden, bevorzugt elektronenziehende Liganden. Beispielsweise genannt seien die Anionen von elektronenziehenden Carbonsäuren, wie beispielsweise CHalₓH₃₋ₓCOOH, insbesondere CFₓH₃₋ₓCOOH und CClₓH₃₋ₓCOOH (wobei x eine ganze Zahl zwischen 0 und 3 ist und Hal ein Halogenatom darstellt), (CR₁,R₂,R₃)COOH, wobei R₁, R₂ und R₃ unabhängig voneinander Alkyl, wie besonders bevorzugt H, methyl, ethyl, propyl, isopropyl, n- Butyl, sec- Butyl, tert-Butyl, sowie Benzoesäure und deren substituierte Analoga (o, p, m-Fluorbenzoesäure, o,p,m- Cyanobenzoesäure, Nitrobenzoesäure, Alkylbenzoesäuren mit fluorierten oder teilweise fluorierten Alkylgruppen, ggf. auch ein oder mehrfach substituiert, Pyridincarbonsäuren etc.) sein kann.

Die erfindungsgemäß verwendeten mehrkernigen Metallkomplexe stellen vorzugsweise Moleküle dar, die unabhängig voneinander verdampfbar sind. Dabei versteht sich, dass einzelne Metallkomplexe jeweils untereinander oder mit anderen Komponenten wie dem Matrixmaterial gebunden sein können.

Rein formal könnten die Valenzelektronen des PDW-2 wie folgt berechnet werden:
In der Gruppe IX mit 4 einfach negativ geladenen zweizähnigen Liganden ergibt sich folgendes Bild für Metall-Metall:
   4 x 4e = 16 Elektronen von den Liganden
   1 x 2e = 2 von der Einfachfachbindung zwischen Rh-Rh
   2 x 9e = 18 vom Rhodium
   Summe 36, damit hat jedes Rh Edelgaskonfiguration d.h. stabil Alternativ ergibt sich die Summe 36 für andere Metalle bei gleichen Liganden:
   Metalle der Gruppe 6: Metall - Metall-Vierfachbindung d.h. σ, 2 x π, 1 x δ-Bindung besetzt
   Metalle der Gruppe 7: Metall - Metall-Dreifachbindung d.h. σ, 2 x π, 1 x δ-Bindung, 1 x δ* besetzt
   Metalle der Gruppe 8: Metall - Metall-Zweifachbindung d.h. σ, 2 x π, 1 x δ-Bindung, 1 x δ*, 1 x π* besetzt
   Metalle der Gruppe 9: Metall - Metall-Einfachbindung d.h. σ, 2 x π, 1 x δ-Bindung, 1 x δ*, 2 x π* besetzt

Dabei versteht sich, dass einzelne Metallkomplexe jeweils untereinander oder mit anderen Komponenten wie dem Matrixmaterial gebunden sein können. Durch die Bindungsbildung der Donator-Akzeptorwechselwirkung und die Molekülgröße werden die Dopanten in der Matrix fixiert.

Als organische Matrixmaterialien eignen sich alle gängigen Lochleitermatrizen, wie beispielsweise NPB; Naphdata; N,N'-Bis(naphthalen-1-yl)-N,N'-bis(phenyl)-benzidine; N,N'-Bis(naphthalen-2-yl)-N,N'-bis(phenyl)-benzidine; N,N'-Bis(3-methylphenyl)-N,N'-bis(phenyl)-benzidine; N,N'-Bis(3-methylphenyl)-N,N'-bis(phenyl)-9,9-spirobifluorene; N,N'-Bis(naphthalen-1-yl)-N,N'-bis(phenyl)-9,9-spirobifluorene; N,N'-Bis(3-methylphenyl)-N,N'-bis(phenyl)-9,9-dimethyl-fluorene; N,N'-Bis(3-naphthalen-1-yl)-N,N'-bis(phenyl)-9,9-dimethyl-fluorene; N,N'-Bis(3-methylphenyl)-N,N'-bis(phenyl)-9,9-diphenyl-fluorene; N,N'-Bis(3-naphthalen-1-yl)-N,N'-bis(phenyl)-9,9-diphenyl-fluorene; 2,2',7,7'-Tetrakis(N,N-diphenylamino)-9,9'-spirobifluorene; 9,9-Bis[4-(N,N-bis-biphenyl-4-yl-amino)phenyl]-9H-fluorene; 9,9-Bis[4-(N,N-bis-naphthalen-2-yl-amino)phenyl]-9H-fluorene; 9,9-Bis[4-(N,N'-bis-naphthalen-2-yl-N,N'-bis-phenyl-amino)-phenyl]-9H-fluorene; 2,2',7,7'-Tetrakis[(N-naphthalenyl(phenyl)-amino]-9,9-spirobifluorene; N,N'-bis(phenanthren-9-yl)-N,N'-bis(phenyl)-benzidine; 2,7-Bis[N,N-bis(9,9-spiro-bifluorene-2-yl)-amino]-9,9-spirobifluorene; 2,2'-Bis[N,N-bis(biphenyl-4-yl)amino]-9,9-spirobifluorene; 2,2'-Bis(N,N-di-phenyl-amino)-9,9-spirobifluorene; Phthalocyanine-Coppercomplex; 4,4',4"-Tris(N-3-methylphenyl-N-phenyl-amino)triphenylamine; 4,4',4"-Tris(N-(2-naphthyl)-N-phenyl-amino)triphenylamine; 4,4',4"-Tris(N-(1-naphthyl)-N-phenyl-amino)triphenylamine; 4,4',4'-Tris(N,N-diphenyl-amino)triphenylamine; Titanium oxide phthalocyanine; 2,3,5,6-Tetrafluoro-7,7,8,8,-tetracyano-quinodimethane; Pyrazino[2,3-f][1,10]phenanthrolone-2,3-dicarbonitrile; N,N,N',N'-Tetrakis(4-methoxyphenyl)benzidine; 2,7-Bis[N,N-bis(4-methoxy-phenyl)amino]-9,9-spirobifluorene; 2,2'-Bis[N,N-bis(4-methoxy-phenyl)amino]-9,9-spirobifluorene; 1,3-Bis(carbazol-9-yl)benzene; 1,3,5-Tris(carbazol-9-yl)benzene; 4,4',4"-Tris(carbazol-9-yl)triphenylamine; 4,4'-Bis(carbazol-9-yl)biphenyl; 4,4'-Bis(9- carbazolyl)-2,2'-dimethyl-biphenyl; 2,7-Bis(carbazol-9-yl)-9,9-dimentylfluorene und 2,2',7,7'-Tetrakis(carbazol-9-yl)-9,9'-spirobifluorene.

Die experimentell gefundene Strombegrenzung wurde bisher bei keiner der publizierten für die Dotierung geeigneten Materialsysteme beobachtet. Dieser Aspekt ist für großflächige organische Leuchtdioden besonders wichtig, da er eine Homogenisierung der Leuchtdichte bewirkt. Feldüberhöhungen an Partikeln oder Spitzen im Substratmaterial werden durch Schichten mit Strombegrenzung ausgeglichen, da der maximale Stromfluss nicht mehr vom angelegten Feld abhängt.

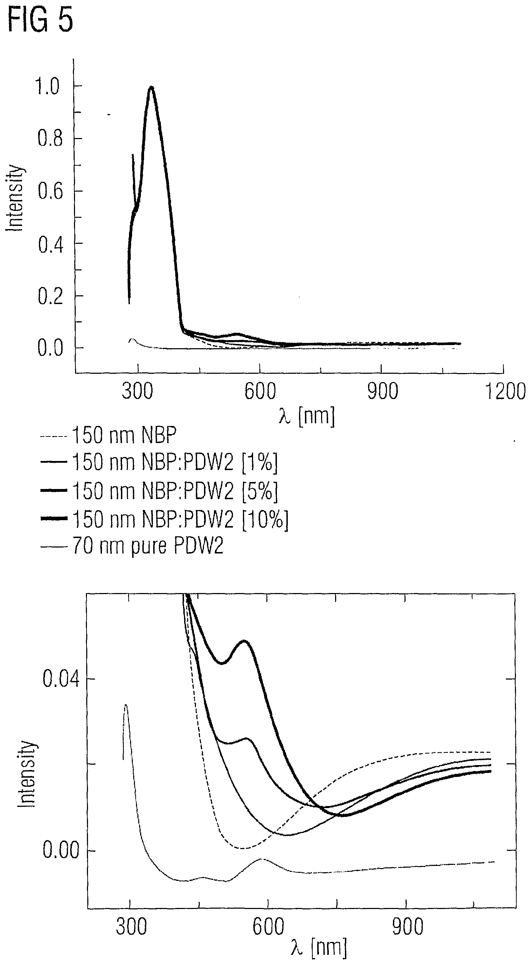

Im Folgenden wird die Erfindung noch anhand einiger experimenteller Ergebnisse verdeutlicht:
Beispiel zu Figur 5:
   Analog zum oben beschriebenen Experiment wird PDW-2 durch Koverdampfung in den Lochleiter NPB (= Bis-N,N,N',N'-(naphthyl-phenyl)benzidin) eindotiert. Für eine Dotierung von 0%, 1%, 5% und 10% und 100% PDW2 ergeben sich die in Figur 5 dargestellten Kennlinien.

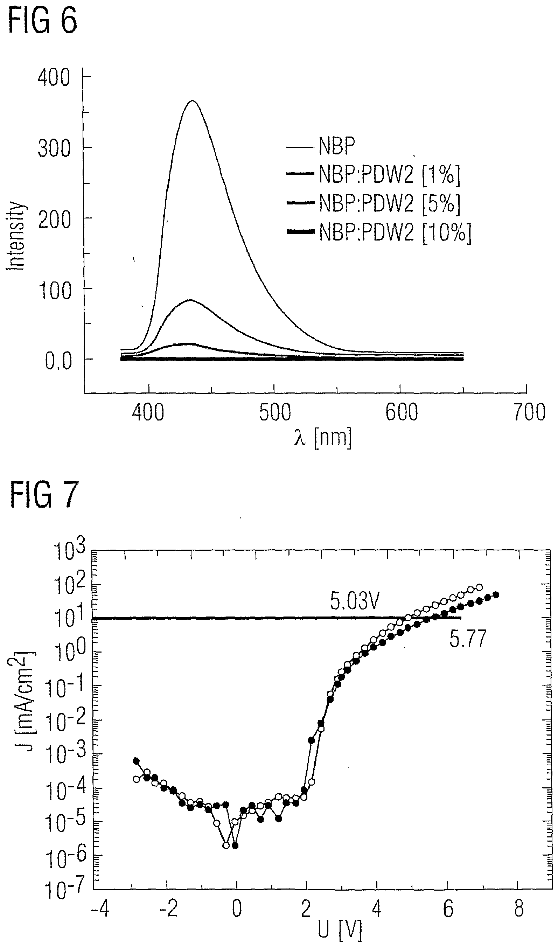

   Eine zusätzliche Bande im UV-Spektrum im Bereich zwischen 550-600 nm zeigt die Dotierfähigkeit von NPB durch PDW-2.
   Die Grafik von Figur 6 zeigt das Photolumineszenzspektrum der im oben beschriebenen Beispiel zu Figur 5 dargestellten Schichten. Bei Anregung der Schicht mit UV-Licht von 342 nm nimmt die Fluoreszenz der NPB Schicht stetig ab. Ganz im Einklang zu anderen Dotanten löscht auch PDW-2 die Fluoreszenz.
Beispiel zu Figur 7:
   Auf einer ITO (Indium-tin-oxide = indiumdotiertes Zinnoxid) Elektrode werden nacheinander durch thermisches Verdampfen folgende Schichten abgeschieden, um eine organische Leuchtdiode auf zu bauen (Alq = Aluminiumtrishydroxychinolinat, LiF = Lithiumfluorid).
      a. 50 nm NPB; 40 nm NPB; 40 nm Alq; 0.7 nm LiF; 200 nm A1 (Kreise voll)
      b. 50 nm NPB:PDW-2 [10%]; 40 nm NPB; 40 nm Alq; 0.7 nm LiF; 200 nm A1 (Kreise leer)

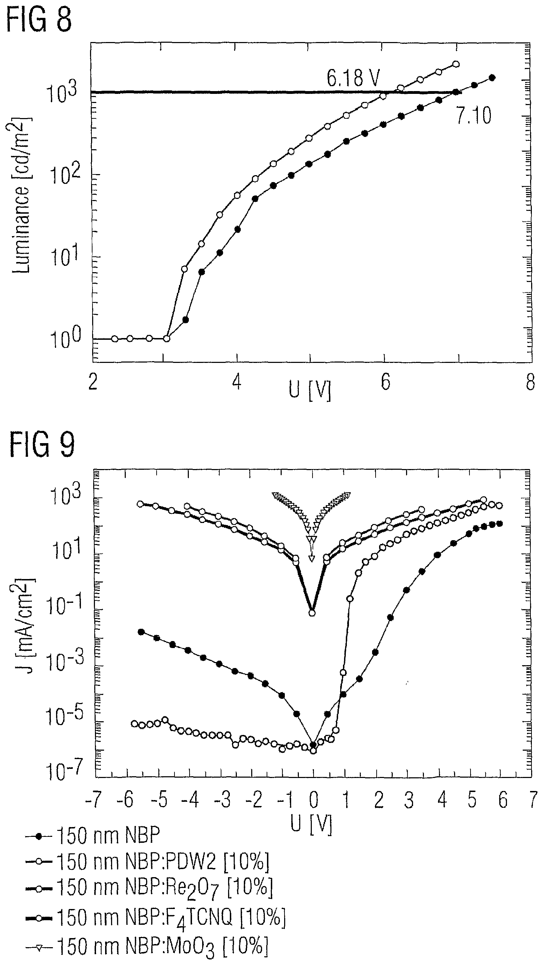

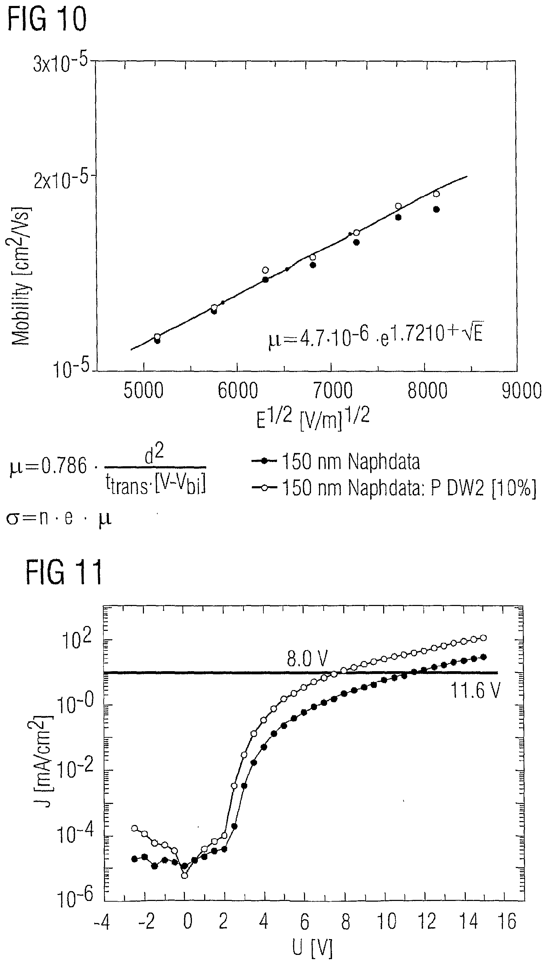

   Durch den Einsatz der dotierten Lochinjektionsschicht wird in der I-V-Kennlinie die Spannung von 5.77 V auf 5.03 V reduziert, um eine Stromdichte von 10 mA/cm² zu erreichen. Die Effizienz dieser Diode wird dadurch deutlich verbessert, wie aus Figur 7 ersichtlich ist.
   Durch die Reduzierung der Versorgungsspannung wird die Leuchtdichte von 1000 cd/m² schon bei 6.18 V mit der dotierten Lochinjektionsschicht und erst bei 7.10V mit der undotierten Lochinjektionsschicht erreicht (Figur 8).
Beispiel zu Figur 9:
   PDW-2 ist in Aufbauten analog dem Beispiel zu Figur 5 ähnlich effizient, wie andere literaturbekannte Dopanden z.B. MoO₃ oder F₄TCNQ wie der hier gezeigte Vergleich beweist.
Beispiel zu Figur 10:
   Die Ladungsträgerdichte kann in anderen Lochleitern wie Naphdata durch den Dopanden PDW-2 ebenfalls erhöht werden.

   Transiente Dunkelstrommessungen zeigen, dass bei einer Dotierung von 10% PDW-2 in Naphdata die Mobilität nahezu konstant bleibt. Wie das Beispiel zu Fig. 10 demonstriert, steigt die für die organische Leuchtdiode zur Verfügung stehende Ladungsträgerdichte stark an, was sich sehr positiv auf die Kennlinien von organischen Leuchtdioden auswirkt. (σ = Leitfähigkeit, µ = Mobilität, n = Zahl der Ladungsträger, e = Elementarladung)
Beispiel zu Figur 11:
   Eine analog Beispiel zu Figur 7 aufgebaute Leuchtdiode mit Naphdata statt NPB in der Lochinjektionsschicht.
      a. 50 nm Naphdata; 40 nm NPB; 40 nm Alq; 0.7 nm LiF; 200 nm A1 (Kreise voll)
      b. 50 nm Naphdata:PDW-2 [10%]; 40 nm NPB; 40 nm Alq; 0.7 nm LiF; 200 nm A1 (Kreise leer)

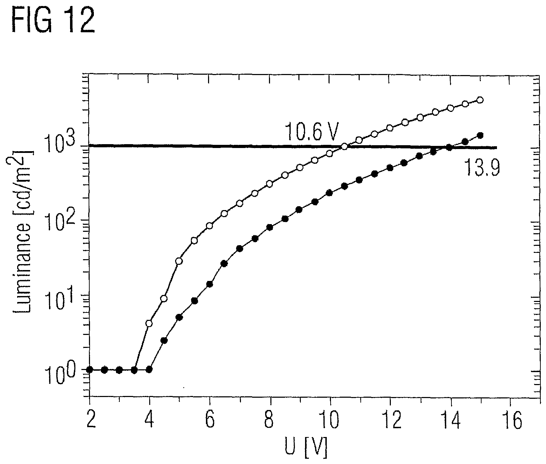

   Durch den Einsatz der dotierten Lochinjektionsschicht wird in der I-V-Kennlinie die Spannung von 11.6 V auf 8.0 V reduziert, um eine Stromdichte von 10 mA/cm² zu erreichen. Die Effizienz dieser Diode wird dadurch deutlich verbessert (Figur 11)
Beispiel zu Figur 12:
   Durch die Reduzierung der Versorgungsspannung wird die Leuchtdichte von 1000 cd/m² schon bei 10.6 V mit der dotierten Lochinjektionsschicht und erst bei 13.9 V mit der undotierten Lochinjektionsschicht erreicht (Figur 12).

Die experimentell gefundene Strombegrenzung wurde bisher bei keiner der publizierten für die Dotierung geeigneten Materialsysteme beobachtet. Dieser Aspekt ist für großflächige organische Leuchtdioden besonders wichtig, da er eine Homogenisierung der Leuchtdichte bewirkt. Feldüberhöhungen an Partikeln oder Spitzen im Substratmaterial werden durch Schichten mit Strombegrenzung ausgeglichen, da der maximale Stromfluss nicht mehr vom angelegten Feld abhängt.

Die Erfindung zeichnet sich insbesondere dadurch aus, dass die verwendeten Materialien OLED kompatibel sind und dass beispielsweise in den bevorzugten zweikernigen Metallkomplexen mit der Metall-Metallbindung formal die Ladung beim Stromtransport im Molekül auf zwei Metallatome verteilt wird, was zur Stabilität der Gesamtschicht beiträgt.

Die Erfindung betrifft die Verwendung eines mehrkernigen Metallkomplexes als p-Dotand für ein organisches halbleitendes Matrixmaterial, ein organisches Halbleitermaterial und eine organische Leuchtdiode. Die Erfindung offenbart dabei die Verwendung von mehrkernigen Metallkomplexen, die als Lewis-Säuren fungieren als p-Dotanden in organischen Matrixmaterialien.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verwendung eines mehrkernigen Metallkomplexes als p-Dotand zur Dotierung eines lochleitenden organischen Matrixmaterials, wobei der mehrkernige Metallkomplex ein Metallkomplex mit Lewissäureeigenschaft ist und als Elektronenpaarakzeptor wirkt.

2. Verwendung nach Anspruch 1, wobei das Zentralatom des Metallkomplexes ein neutrales oder geladenes Übergangsmetallatom ist.

3. Verwendung nach einem der vorstehenden Ansprüche, wobei zumindest ein Zentralatom aus der 6. bis 9. Nebengruppe ausgewählt ist.

4. Verwendung nach dem vorhergehenden Anspruch, wobei zumindest ein Zentralatom Rhodium ist.

5. Verwendung nach einem der vorstehenden Ansprüche, wobei der Metallkomplex ein mehrkerniger Metallkomplex ist, bei dem zumindest ein Ligand zwei Zentralatome koordinativ verbindet.

6. Verwendung nach einem der vorstehenden Ansprüche, wobei zumindest ein Zentralatom quadratisch planar von Liganden umgeben ist.

7. Verwendung nach einem der vorstehenden Ansprüche, wobei der Metallkomplex und symmetrisch aufgebaut ist.

8. Verwendung nach einem der vorstehenden Ansprüche, wobei die Liganden Carbonsäuren oder Carbonsäureanionen mit elektronenziehenden Substituenten sind.

9. Verwendung nach einem der vorstehenden Ansprüche, wobei zumindest ein Metallkomplex eine Schaufelradstruktur hat.

10. Halbleitendes Material, insbesondere organisches halbleitendes Material enthaltend zumindest ein organisches Matrixmaterial und einen p-Dotanden nach einem der Ansprüche 1 bis 9.

11. Organisches halbleitendes Material nach Anspruch 10, wobei das molare Dotierungsverhältnis von p-Dotand zu monomeren Einheiten eines polymeren Matrixmoleküls zwischen 1:1 und 1:100.000 beträgt.

12. Verfahren zur Herstellung eines organischen halbleitenden Materials enthaltend ein organisches Matrixmaterial und einen p-Dotanden, wobei als p-Dotand zumindest ein oder mehrere Metallkomplexe nach einem der Ansprüche 1 bis 9 verwendet werden.

13. Strahlungsemittierende Vorrichtung enthaltend ein organisches halbleitendes Material nach Anspruch 10 oder 11.

14. Strahlungsemittierende Vorrichtung nach dem vorhergehenden Anspruch, wobei die strahlungsemittiernde Vorrichtung eine organische Leuchtdiode ist, die zwei Elektroden eine Lochleitschicht und eine emittierende Schicht umfasst, wobei die Lochleitschicht einen oder mehrere Metallkomplexe nach einem der Ansprüche 1 bis 9 enthält.

## Claims

1. Use of a polynuclear metal complex as p-dopant for doping a hole-conducting organic matrix material, the polynuclear metal complex being a metal complex having Lewis acid property and acting as electron pair acceptor.

2. Use according to Claim 1, the central atom of the metal complex being a neutral or charged transition metal atom.

3. Use according to either of the preceding claims, at least one central atom being selected from transition groups 6 to 9.

4. Use according to the preceding claim, at least one central atom being rhodium.

5. Use according to any of the preceding claims, the metal complex being a polynuclear metal complex in which at least one ligand coordinatively connects two central atoms.

6. Use according to any of the preceding claims, at least one central atom being surrounded in square-planar configuration by ligands.

7. Use according to any of the preceding claims, the metal complex and being symmetrically constructed.

8. Use according to any of the preceding claims, the ligands being carboxylic acids or carboxylic acid anions having electron-withdrawing substituents.

9. Use according to any of the preceding claims, at least one metal complex having a paddle wheel structure.

10. Semiconducting material, in particular organic semiconducting material, comprising at least one organic matrix material and a p-dopant according to any of claims 1 to 9.

11. Organic semiconductor material according to claim 10, the molar doping ratio of p-dopant to monomer units of a polymeric matrix molecule being between 1:1 and 1:100,000.

12. Method for producing an organic semiconducting material comprising an organic matrix material and a p-dopant, using as p-dopant at least one or more metal complexes according to any of claims 1 to 9.

13. Radiation-emitting device comprising an organic semiconducting material according to claim 10 or 11.

14. Radiation-emitting device according to the preceding claim, the radiation-emitting device being an organic light-emitting diode which comprises two electrodes a hole-conducting layer and an emitting layer, the hole-conducting layer comprising one or more metal complexes according to any of claims 1 to 9.

## Revendications

1. Utilisation d'un complexe métallique polynucléaire comme dopant p pour doper un matériau matrice organique conducteur de trous, le complexe métallique polynucléaire étant un complexe métallique avec des propriétés d'acide de Lewis et fonctionnant comme accepteur de paires d'électrons.

2. Utilisation selon la revendication 1, dans laquelle l'atome central du complexe métallique est un atome de métal de transition neutre ou chargé.

3. Utilisation selon l'une des revendications précédentes, dans laquelle au moins un atome central est choisi dans les groupes 6 à 9 des métaux de transition.

4. Utilisation selon l'une des revendications précédentes, dans laquelle au moins un atome central est du rhodium.

5. Utilisation selon l'une des revendications précédentes, dans laquelle le complexe métallique est un complexe métallique polynucléaire, dans lequel au moins un ligand relie deux atomes centraux par liaison de coordination.

6. Utilisation selon l'une des revendications précédentes, dans laquelle au moins un atome central est entouré de ligands avec une géométrie plane quadratique.

7. Utilisation selon l'une des revendications précédentes, dans laquelle le complexe métallique est de conception symétrique.

8. Utilisation selon l'une des revendications précédentes, dans laquelle les ligands sont des acides carboxyliques ou des anions acides carboxyliques avec des substituants électroattracteurs.

9. Utilisation selon l'une des revendications précédentes, dans laquelle au moins un complexe métallique a une structure en roue à aube.

10. Matériau semi-conducteur, en particulier matériau organique semi-conducteur contenant au moins un matériau matrice organique et un dopant p selon une des revendications 1 à 9.

11. Matériau organique semi-conducteur selon la revendication 10, le rapport molaire de dopage du dopant p aux unités monomères d'une molécule matrice polymère se situe entre 1:1 et 1:100 000.

12. Procédé de fabrication d'un matériau organique semi-conducteur contenant un matériau matrice organique et un dopant p, dans lequel on utilise comme dopant p au moins un ou plusieurs complexes métalliques selon une des revendications 1 à 9.

13. Dispositif luminescent contenant un matériau organique semi-conducteur selon la revendication 10 ou 11.

14. Dispositif luminescent selon l'une des revendications précédentes, le dispositif luminescent étant une diode électroluminescente organique qui comprend deux électrodes une couche conductrice de trous et une couche émettrice, la couche conductrice de trous contenant au moins un complexe métallique selon une des revendications 1 à 9.
